# FASCICULE DE BREVET EUROPEEN

(11) **EP 1 036 489 B1**
(45) Date de publication et mention de la délivrance du brevet: **01.10.2003**
(21) Numéro de dépôt: 98955735.0
(22) Date de dépôt: 24.11.1998
(51) Int. Cl.: H05K 1/18, H01L 23/66

(54) **PROCEDE DE MONTAGE EN SURFACE D'UN BOITIER HYPERFREQUENCE SUR UN CIRCUIT IMPRIME ET BOITIER ET CIRCUIT IMPRIME POUR LA MISE EN OEUVRE DU PROCEDE**
VERFAHREN ZUR OBERFLÄCHENMONTIERUNG EINES MIKROWELLENGEHÄUSES AUF EINER LEITERPLATTE UND GEHÄUSE UND LEITERPLATTE ZUR DURCHFÜHRUNG DES VERFAHRENS
METHOD FOR SURFACE MOUNTING OF A MICROWAVE PACKAGE ON A PRINTED CIRCUIT AND PACKAGE AND PRINTED CIRCUIT FOR IMPLEMENTING SAID METHOD

(30) Priorité: 28.11.1997 FR 9715008; 04.08.1998 FR 9810016
(43) Date de publication de la demande: 20.09.2000
(73) Titulaire: Thales, 75008 Paris (FR)
(72) Inventeur: DADEN, Jean-Yves, Thomson-CSF Propriété Intellect., F-94117 Arcueil Ced. (FR); GOHN-DEVINEAU, Muriel, Thomson-CSF Propiété Intel., F-94117 Arcueil Ced. (FR); CACHIER, Gérard, Thomson-CSF Propiété Intellect., F-94117 Arcueil Ced (FR); ETOURNEAU, Pascal, Thomson-CSF Propiété Intellect., F-94117 Arcueil Ced. (FR); JAHIER, Vincent, Thomson-CSF Propiété Intellect., F-94117 Arcueil Ced. (FR); GRANCHER, Alain, Thomson-CSF Propiété Intellect., F-94117 Arcueil Ced. (FR); MICHEL, Ludovic, Thomson-CSF Propiété Intellect., F-94117 Arcueil Ced. (FR)
(74) Mandataire: Chaverneff, Vladimir
(86) Numéro de dépôt international: FR9802515
(87) Numéro de publication internationale: WO99029148

(56) Documents cités:
- EP-A- 0 718 905
- WO-A-96/27282
- GB-A- 2 286 084
- US-A- 4 543 544
- F. SPEXARTH ET AL.: "Reliable GaAs microwave assembly using Silvar(TM) heat sink and carrier" INTERNATIONAL JOURNAL OF MICROCIRCUITS AND ELECTRONIC PACKAGING., vol. 18, no. 2, 1995, pages 138-145, XP000522301 Reston, VA, US

## Description

La présente invention concerne un procédé de montage d'un boîtier hyperfréquence en surface, comportant une puce électronique, sur un circuit imprimé et un boîtier et un circuit imprimé conçus pour la mise en oeuvre de ce procédé,

il est connu de monter directement une puce électronique, chip dans la littérature anglo-saxonne, sur un circuit imprimé d'accueil ; il est également connu de monter la puce sur un mini circuit imprimé pour former un boîtier hyperfréquence qui est ensuite monté en surface sur le circuit imprimé d'accueil. Dans les deux cas il est connu de réaliser les liaisons avec le circuit imprimé d'accueil par câblage filaire et de couvrir la puce ou le boîtier hyperfréquence avec un capot de protection comme indiqué dans les demandes de brevets WO 96 27 282 et EP0718905. Mais la mise en oeuvre de telles techniques de montage, en quantité, est coûteuse car, pour des fréquences de fonctionnement élevées, elle exige, pour la réalisation du câblage, lors de l'équipement du circuit imprimé d'accueil, l'utilisation de matériel de micro-électronique ; sans un tel matériel II n'est pratiquement pas possible, en utilisant ces techniques de montage, de travailler à des fréquences supérieures à 12 GHZ.

Le but de la présente invention est d'éviter cet inconvénient.

Ceci est obtenu par montage d'un mini circuit imprimé portant la puce sur un circuit imprimé d'accueil, où la face active du mini circuit imprimé portant la puce est soudée sur le circuit imprimé d'accueil et où des plans de masse répartis sur les deux circuits imprimés forment une sorte de cage constituant un blindage autour de la puce.

Selon l'invention il est proposé un procédé de montage d'un boîtier hyperfréquence sur un circuit Imprimé, caractérisé en ce qu'il consiste - à utiliser, pour le boîtier, un boîtier hyperfréquence ayant deux faces parallèles dont une première face avec une puce électronique, des conducteurs connectés à la puce et des plans de masse intercalés entre les conducteurs et une seconde face constituée par un plan de masse connecté aux plans de masse de la première face - à réaliser le circuit imprimé de telle sorte qu'il présente une première face avec, dans une zone dédiée au boîtier, des conducteurs et des plans de masse et une seconde face constituée par un plan de masse connecté aux plans de masse de la première face du circuit imprimé, les deux premières faces ayant d'une part leurs plans de masse et d'autre part leurs conducteurs qui, dans une position prédéterminée du boîtier sur le circuit imprimé, sont en contact biunivoque, - à placer le boîtier dans la position prédéterminée - et à connecter le boîtier au circuit imprimé par soudure des conducteurs et des plans de masse en contact biunivoque.

Selon l'invention il est proposé un boîtier hyperfréquence, pour la mise en oeuvre d'un procédé de montage d'un boîtier sur un circuit imprimé, ce boîtier hyperfréquence comportant un mini circuit imprimé avec une première et une seconde face, la première face comportant une puce électronique et des conducteurs connectés à la puce et la seconde face étant constituée par un plan de masse, caractérisé en ce que la première face comporte des plans de masse, en ce que ces plans de masse sont intercalés entre les conducteurs et en ce que le mini circuit imprimé comporte des connexions entre les plans de masse de la première face et le plan de masse de la seconde face.

Selon l'invention il est proposé un circuit imprimé d'accueil de boîtier hyperfréquence, pour la mise en oeuvre d'un procédé de montage d'un boîtier sur un circuit imprimé, ce circuit imprimé d'accueil comportant une première et une seconde face, la première face comportant, dans une zone d'accueil, des conducteurs et la seconde face étant constituée par un plan de masse, caractérisé en ce que la première face comporte des plans de masse dans la zone d'accueil, en ce que ces plans de masse sont intercalés entre les conducteurs et en ce que le circuit imprimé d'accueil comporte des connexions entre les plans de masse de la première face et le plan de masse de la seconde face.

La présente invention sera mieux comprise et d'autres caractéristiques apparaîtront à l'aide de la description ci-après et des figures s'y rapportant qui représentent :
- les figures 1 et 2, les vues de celle des faces de deux circuits imprimés ; il s'agit de la face qui porte, entre autres éléments, des conducteurs, et la vue selon la figure 2 est une vue partielle,
- la figure 3, une vue en coupe des circuits imprimés des figures 1 et 2, après qu'ils aient été réunis par soudure,
- la figure 4, une vue en perspective d'une variante de réalisation à l'un des éléments décrits à l'aide de la figure 3,
- les figures 5 à 7, des vues correspondant respectivement aux vues des figures 1 à 3 mais dans une variante de réalisation qui comporte l'élément selon la figure 4.

Sur les différentes figures les éléments correspondants sont désignés par les mêmes repères.

Dans ce qui suit et dans les revendications quand il sera question d'un circuit imprimé dont un des deux côtés est entièrement métallisé et que ce côté sera soudé sur un support métallique, il sera considéré que le support métallique fait partie du circuit imprimé et en constitue le plan de masse.

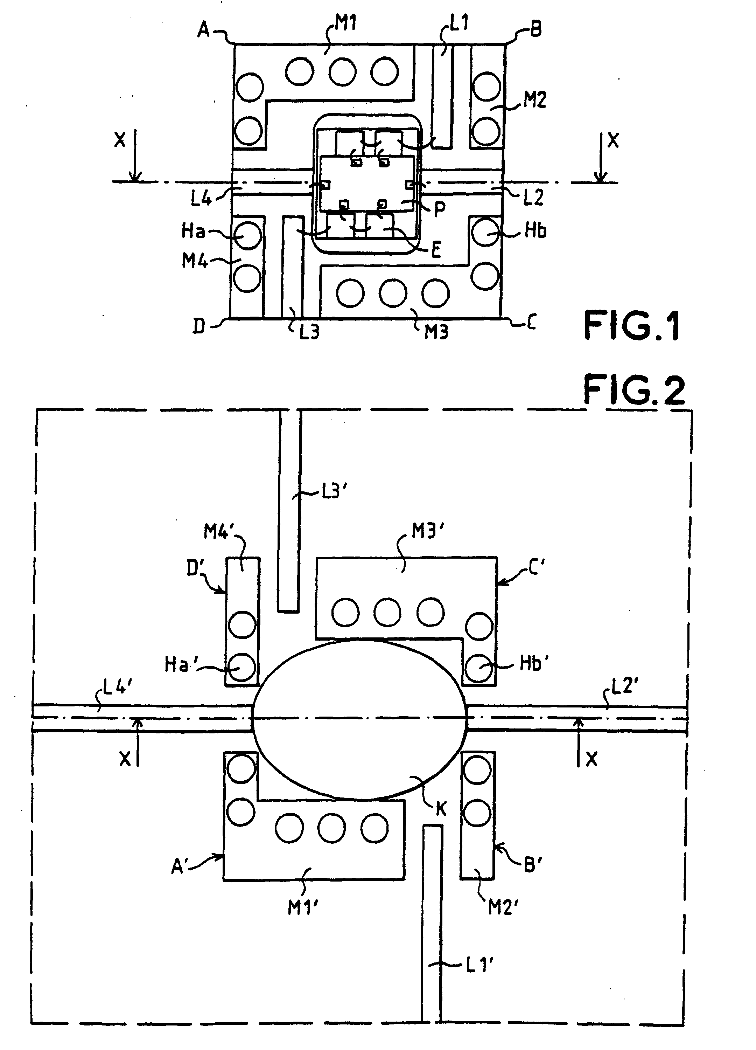

La figure 1 montre un boîtier hyperfréquence d'une puce électronique, P ; il est constitué par un mini circuit imprimé dont la figure 1 montre une face carrée, ABCD, avec des pistes conductrices L1 à L4, des plans de masse M1 à M4, intercalés entre les pistes, et la puce P associée à quatre éléments de découplage tels que E. La puce P est située sensiblement au milieu de la face ABCD ; des fils soudés à leurs extrémités assurent les liaisons entre les différents éléments de ce boîtier.

Les pistes L2, L4 sont connectés respectivement à deux accès hyperfréquence de la puce tandis que les pistes L1, L3 amènent des tensions de polarisation à la puce. Chacun des plans de masse M1 à M4 est percé de trous tels que Ha, Hb ; au total il y a quatorze trous répartis au voisinage de la périphérie du carré ABCD.

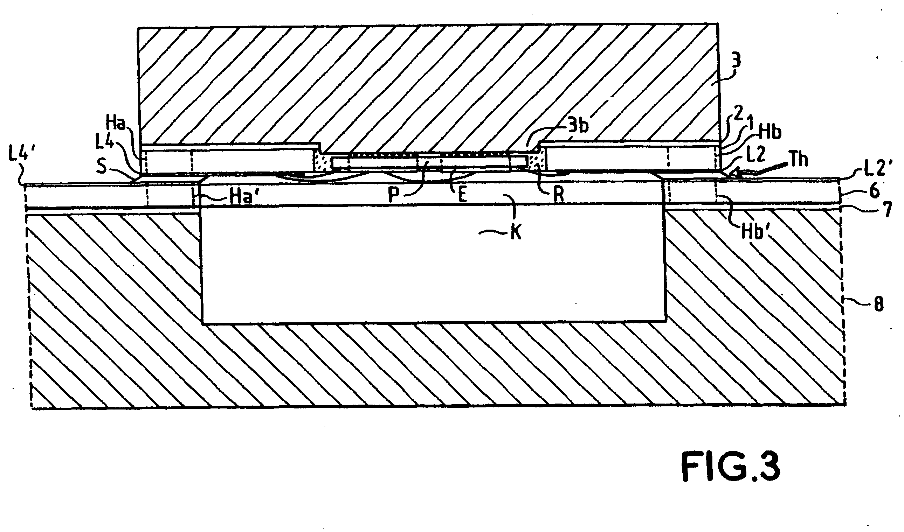

Le boîtier est représenté en coupe, dans un rectangle situé à la partie supérieure de la figure 3 ; le plan de coupe, de trace XX, est perpendiculaire au plan de la figure 1 et est parallèle aux pistes L2, L4 en leur milieu. La figure 3 comporte, de plus, un rectangle inférieur, accoté au rectangle du boîtier ; ce rectangle correspond à une vue en coupe d'un circuit imprimé sur lequel repose la face ABCD du boîtier ; le boîtier est dit monté en surface sur le circuit imprimé.

Le mini circuit imprimé du boîtier comporte un substrat isolant 1 avec, d'un côté, la face représentée sur la figure 1 et, de l'autre côté, un plan de masse en trois couches successives : un dépôt métallique et de la soudure, 2, et un support mécanique conducteur, en laiton, 3 ; pour la facilité du dessin le dépôt métallique sur le substrat 1 et la soudure entre ce dépôt et le support mécanique 3, ont été confondus sur le dessin de la figure 3 pour ne montrer qu'une couche conductrice 2.

Le boîtier présente la particularité, par rapport à un boîtier classique où le support, 3, est une simple plaque en laiton à faces parallèles, de posséder un bossage ou tab 3b dans son support, du côté du substrat, au niveau d'un trou pratiqué dans le substrat pour souder la puce P sur le plan de masse. Habituellement, c'est-à-dire sans le bossage 3b, la puce P est soudée sur le plan de masse, directement sur le support 3 ; sa face opposée au plan de masse est à une distance donnée de la face du mini circuit imprimé qui porte les pistes L1 à L4. Quand, pour la protéger, de la résine est déposée sur la puce, il s'avère impossible de n'avoir que la fine couche de résine strictement nécessaire à la protection ; la résine, en modifiant alors fortement le milieu de propagation du côté des liaisons de la puce, perturbe le fonctionnement au delà de fréquences supérieures à 10 GHz. La présence du bossage 3b réduit fortement ladite distance donnée ; celle des faces du mini circuit imprimé qui porte les pistes L1 à L4 est alors utilisée comme niveau de référence pour la quantité de résine à déposer, ce qui permet de maîtriser l'épaisseur de résine sur la puce.

La figure 3 montre, en pointillés, les trous Ha, Hb dont il a été question lors de la description de la figure 1 ; il s'agit, comme pour les douze autres trous percés dans les plans de masse M1 à M4, de trous à parois métallisées qui constituent des colonnes conductrices parallèles, entre le plan de masse 2, 3 et les plans de masse M1 à M4.

La figure 2 est une vue partielle d'un circuit imprimé d'accueil, dans sa partie dédiée au boîtier qui vient d'être décrit ci-avant à l'aide de la figure 1 et du rectangle de la partie supérieure de la figure 3. Le rectangle de la partie inférieure de la figure 3 correspond à une vue en coupe du circuit imprimé de la figure 2, dans un plan de coupe de trace XX ; le plan de coupe est perpendiculaire au plan de la figure 2. Il est à noter que c'est volontairement que les traces de coupe portent la même référence sur les figures 1 et 2 ; c'est pour marquer le fait que, lorsque le boîtier est montée dans la position prédéterminée qu'il doit occuper sur le circuit imprimé, les deux plans de coupe sont confondus.

Le circuit imprimé, selon la figure 2 et selon la partie inférieure de la figure 3, comporte un substrat isolant 6 avec, d'un côté des pistes conductrices L1' à L4', et des plans de masse, M1' à M4', représentés sur la figure 2 et, de l'autre côté, un plan de masse en trois couches successives : un dépôt métallique et de la soudure, 7, et un support mécanique en laiton, 8 ; là aussi, pour la facilité du dessin, le dépôt métallique sur le substrat 6 et la soudure entre ce dépôt et le support mécanique 8, ont été confondus sur le dessin de la figure 3.

Les pistes L2', L4' sont des pistes hyperfréquence que le plan de coupe traverse longitudinalement en leur milieu et les pistes L1', L3' sont des pistes destinées à amener des tensions de polarisation.

Chacun des plans de masse M1' à M4' est percé de trous tels que Ha', Hb'. Ces trous dont la paroi est métallisée assurent une liaison conductrice entre les plans de masse M1' à M4' situés d'un côté du circuit imprimé et le plan de masse 7, 8 situé de l'autre côté du circuit imprimé.

Sur la figure 2 quatre points A', B', C', D' formant les sommets d'un carré, ont été repérés par des flèches ; ils correspondent aux positions exactes que doivent occuper respectivement les sommets ABCD de la face du mini circuit imprimé représenté sur la figure 1, lors du montage du boîtier sur le circuit imprimé d'accueil ; c'est dans cette position du boîtier par rapport à son circuit imprimé d'accueil qu'est effectuée la coupe suivant la figure 3. Il est à remarquer, en comparant les figures 1 et 2, que les plans de masse et les orifices des trous métallisés situés dans le carré A'B'C'D' correspondent point pour point, dans une symétrie par rapport à un plan, aux plans de masse et aux orifices des trous métallisés situés dans le carré ABCD ; pour les pistes conductrices cette symétrie existe aussi mais vis-à-vis seulement d'une partie des pistes du carré ABCD car les pistes s'étendent moins loin à l'intérieure du carré A'B'C'D' qu'à l'intérieur du carré ABCD. Ainsi, quand les sommets ABCD du mini circuit imprimé sont respectivement au-dessus des points A'B'C'D', les pistes conductrices L1' à L4' et les plans de masse M1' à M4' sont entièrement en regard des pistes et des plans de masse correspondants du boîtier ; de plus les quatorze trous métallisés du boîtier sont dans le prolongement des quatorze trous métallisés du circuit imprimé d'accueil.

La connexion du boîtier sur son circuit d'accueil consiste, dans l'exemple décrit, à appliquer d'abord une fine couche de soudure sur les pistes et les plans de masse qui se trouvent en regard quand le carré ABCD est au-dessus du carré A'B'C'D' ; puis le boîtier est positionné sur le circuit d'accueil de telle manière que le carré ABCD soit exactement au-dessus du carré A'B'C'D' et que, par thermosoudure, les pistes en regard et les plans de masse en regard puissent être soudés. Sur la figure 3 l'apport de calorie assurant la thermosoudure a été symbolisé par une flèches Th ; quant à la couche de soudure qui relie les pistes L4 et L4' après thermosoudure, elle a été notée S sur la figure 3.

Ainsi monté sur le circuit imprimé d'accueil, le boîtier a sa puce qui est enfermée dans une sorte de cage, formant blindage, limitée vers le haut par le plan de masse 2, 3, vers le bas par le plan de masse 7, 8 et latéralement par les quatorze couples de trous métallisés du boîtier - par couple de trous métallisés il faut entendre les trous tels que Ha et Ha' qui se trouvent dans le prolongement l'un de l'autre lors du montage du boîtier sur son circuit imprimé d'accueil, ainsi que l'épaisseur de soudure entre les trous tels que Ha et Ha'.

Les figures 2 et 3 montrent que le circuit imprimé d'accueil est percé d'une cavité, K, de section ovale qui s'ouvre sous la puce P quand le boîtier est monté sur le circuit imprimé d'accueil. Les dimensions de cette cavité sont telles que, par rapport au même montage mais sans cavité, la distance de fa puce P aux parois les plus proches du plan de masse 7, 8 est de l'ordre de cinq fois plus grande ; cette cavité a pour rôle d'éviter des perturbations dans le fonctionnement de la puce, dues au rayonnement à une trop grande proximité d'un plan métallique, en l'occurrence le plan de masse 7, 8.

En variante à l'exemple décrit ci-avant la puce P peut être montée de façon classique, c'est-à-dire sur un plan de masse tel que 2, 3 sans le bossage tel que 3b ; la puce peut également ne pas être protégée par un dépôt de résine, étant donné que, après montage du boîtier sur son circuit imprimé d'accueil, la puce se trouve dans un espace quasiment clos dont l'étanchéité peut d'ailleurs être améliorée par un joint en un matériau isolant, par exemple une colle, disposé tout autour du boîtier, au niveau de la jonction boîtier-circuit imprimé d'accueil ; compte tenu des performances à atteindre, il est même possible, dans certains cas, de ne pas prévoir une cavité dans le circuit imprimé d'accueil, à l'aplomb de la puce.

De plus le boîtier peut être réalisé avec la puce placée sur le mini circuit imprimé selon un montage dit puce à bosse ou flip-chip dans la littérature anglo-saxonne ; mais ce montage où les plots de la puce sont directement en contact avec le mini circuit imprimé ne permet pas une bonne dissipation thermique car la puce n'est plus plaquée sur un plan de masse qui lui sert de radiateur.

Une autre variante aux exemples décrits ci-avant consiste, pour enfermer dans une sorte de cage de Faraday, à remplacer, dans le mini circuit, les trous métallisés par des métallisations effectuées sur la tranche du mini circuit imprimé, entre les bords extérieurs des plans de masse tels que M1 à M4 et le plan de masse tel que 2, 3.

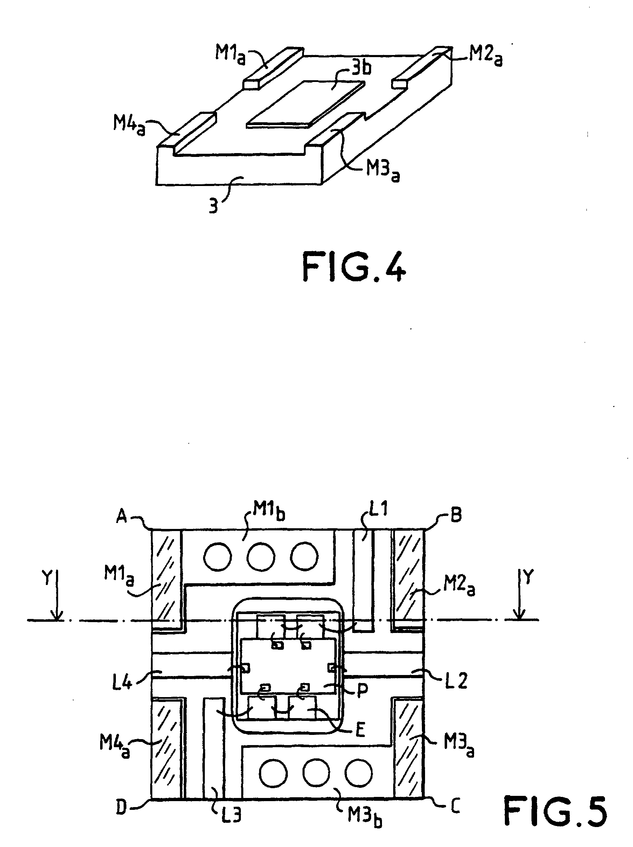

Une variante intéressante à la réalisation du boîtier hyperfréquence et au circuit imprimé d'accueil selon les figures 1 à 3 est décrite ci-après à l'aide des figures 4 à 7.

Le bossage 3b du support mécanique en laiton 3 était, dans la réalisation selon les figures 1 et 3, obtenu par usinage, ce qui est relativement onéreux pour des fabrications en série. Afin de réduire le coût, l'idée a été de substituer la technique de l'emboutissage à celle de l'usinage dans le cas de fabrications en série du support 3. Comme le support 3 est de petite taille, 5 x 5 mm dans l'exemple décrit pour le carré ABCD selon la figure 1, le coût de la matière utilisée est négligeable vis-à-vis du coût de fabrication ; l'économie apportée par l'emboutissage permet de diviser par dix le prix de revient de ce support.

A cette idée de réaliser le bossage 3b par emboutissage s'est ajoutée l'idée de modifier le boîtier hyperfréquence de telle sorte que les quatre plans de masse M1 à M4 du mini circuit imprimé, tels qu'ils apparaissent sur la figure 1, soient remplacés par des plans de masse formés par la face supérieure de bossages convenablement disposés dans le support ; cette idée de plans de masse obtenus par bossages débouchait alors sur l'idée de réaliser ces bossages lors de la même opération d'emboutissage que celle du bossage 3b. Malheureusement il s'est avéré que, dans le cas du boîtier à réaliser, l'importance des bossages était trop grande pour ne pas entraîner, pendant l'emboutissage, des déformations indésirables du bloc de laiton. Afin d'éviter cet inconvénient il a été décidé de ne réaliser qu'une partie des plans M1 à M4 par bossages. Cela a conduit à n'obtenir qu'environ un tiers des plans de masse M1, M3 à l'aide de bossages et à choisir, pour ce tiers, des bossages perpendiculaires aux pistes L2, L4 des accès hyperfréquence ; ce choix a été guidé par une double constatation : - les blindages réalisés par bossages entre plans de masse s'avèrent plus efficaces que ceux réalisés par trous métallisés entre plans de masse, - les blindages perpendiculaires aux pistes ont une plus grande importance que ceux parallèles à ces pistes.

La figure 4 est une vue en perspective d'un support 3 obtenu par emboutissage comme indiqué ci-avant. Sur cette vue apparaissent cinq bossages : le bossage 3b et quatre bossages M1ₐ à M4ₐ.

La figure 5 est une vue qui correspond à la vue selon la figure 1 mais dans une réalisation à l'aide du support 3 selon la figure 4. Cette vue se distingue de celle selon la figure 1 par le fait que les plans de masse M1 à M4 sont partiellement constitués par les faces supérieures des bossages M1ₐ à M4ₐ qui sont laissées à découvert par le substrat du mini circuit imprimé et affleurent au niveau de la face avant du mini circuit imprimé. Pour les distinguer du mini circuit imprimé les faces supérieures des bossages ont été ombrées sur la figure 5.

Il est à noter que, partout où il est proche des bossages M1ₐ à M4ₐ, le mini circuit imprimé porte, sur sa tranche et sur sa face avant, des revêtements cuivreux ; cela permet, lors du montage du mini circuit imprimé sur son support mécanique en laiton 3, une bonne remontée de soudure entre les bossages et le mini circuit imprimé.

Il est à noter également que leur position autour du mini circuit imprimé facilite le montage " support-mini circuit imprimé" ; en effet les bossages servent d'éléments de guidage pour positionner le mini circuit imprimé sur son support.

Les plans de masse M1 à M4 selon la figure 1 sont remplacés, selon la figure 5, par, respectivement, les plans de masse M1ₐ +M1_{b}, M2ₐ,M3ₐ +M3_{b}, M4ₐ Dans ces nouveaux plans de masse les parties M1_{b} M3_{b} sont des revêtements cuivreux portés par la face avant du mini circuit imprimé et sont reliées, par des trous à paroi métallisée, au plan de masse de la face arrière du mini circuit imprimé.

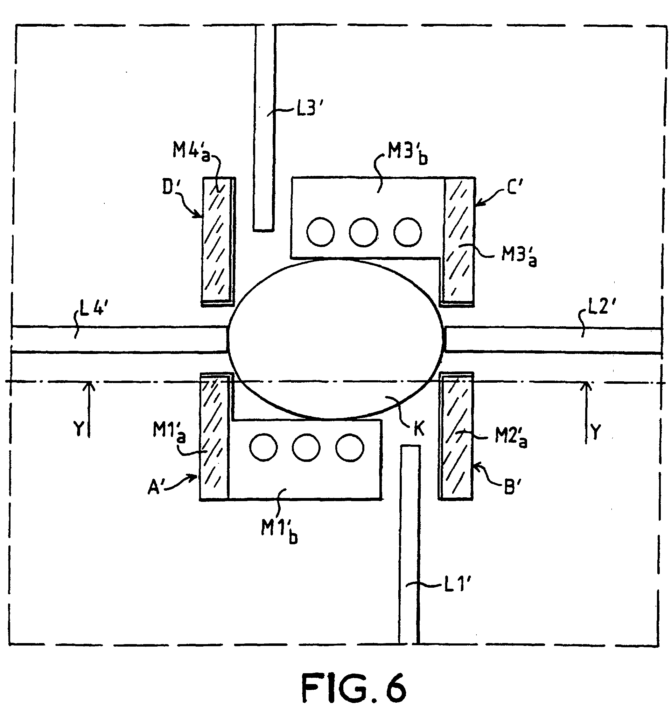

Le circuit imprimé d'accueil selon les figures 2 et 3 peut être utilisé comme circuit d'accueil dédié au boîtier hyperfréquence décrit à l'aide des figures 4 et 5. En variante il est proposé un circuit imprimé d'accueil dont la face avant est représentée, en vue partielle, sur la figure 6. Il s'agit d'un circuit d'accueil qui ne se distingue de celui selon les figures 2 et 3 que par la réalisation de ses plans de masse de la face avant.

Alors que les plans de masse M1' à M4' étaient tous obtenus par des dépôts métallisés, ils sont, dans la variante selon la figure 6, partiellement constitués par les faces supérieures de bossages ; ces bossages sont obtenus par emboutissage d'une plaque en laiton et le support mécanique ainsi réalisé joue le même rôle que le support mécanique 8 selon la figure 3. Ces bossages référencés M1 à M4'ₐ sont disposés de façon à correspondre aux bossages M1ₐ à M4ₐ ; ils donnent ainsi, avec des dépôts cuivreux M1'b à M3'b portés par la face avant du circuit d'accueil, des plans de masse M1'ₐ + M1'_{b}, M2'ₐ, M3'ₐ+M3'_{b}, M4'ₐ qui sont équivalents respectivement aux plans de masse M1 à M4 selon la figure 2.

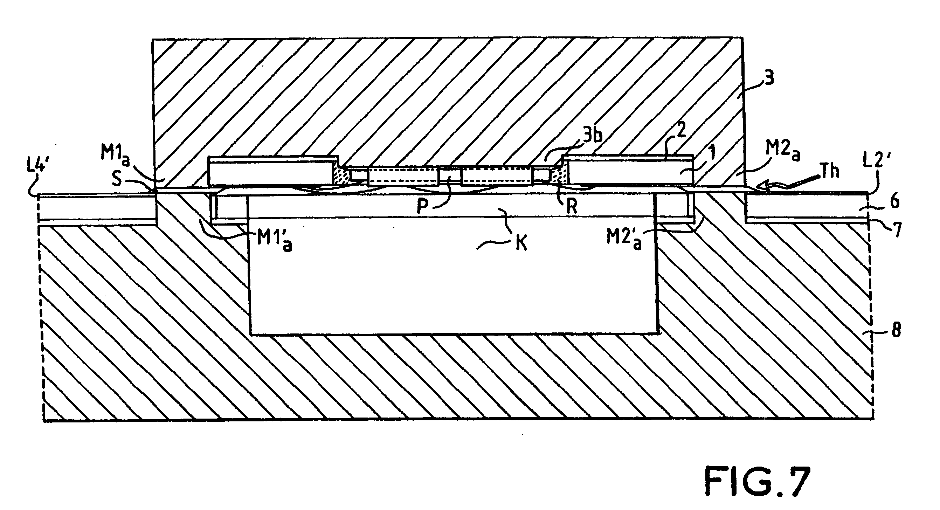

La connexion du boîtier selon les figures 4 et 5 sur son circuit d'accueil selon la figure 6 se fait comme dans la réalisation décrite à l'aide des figures 1 à 3. La figure 7 est une vue en coupe de l'ensemble ainsi réalisé. La trace du plan de coupe est notée YY sur les figures 5 et 6 ; par rapport à la coupe selon la figure 3 le plan de coupe a été décalé de manière à passer par les bossages M1ₐ, M2ₐ, M1'ₐ, M2'ₐ.

Sur la vue en coupe selon la figure 7 les supports ont été notés 3 et 8 pour marquer que malgré leurs bossages tels que M1ₐ et M2ₐ et M1'ₐ et M2'ₐ, ils étaient équivalents aux supports 3 et 8 représentés sur la figure 3.

Il est à noter que, dans la réalisation selon les figures 4 à 7, les bossages M1ₐ -M4ₐ,M1'ₐ-M4'ₐ jouent un double rôle :- plan de masse par leurs faces supérieures - et liaison entre les deux faces du mini circuit imprimé d'une part et les deux faces du circuit imprimé d'accueil d'autre part.

Sur tout ou partie des figures 5 à 7 apparaissent des éléments qui portent les mêmes références 1, 2, 6, 7, K, P..... que des éléments déjà décrits à l'aide des figures 1 à 3. Il s'agit d'éléments équivalents à ceux des figures 1 à 3 si bien que les commentaires qui ont été faits à l'occasion de la description des figures 1 à 3, par exemple relativement à la cavité K, restent valables dans le cadre des figures 5 à 7.

## Revendications

1. Procédé de montage d'un boîtier hyperfréquence sur un circuit imprimé d'accueil, **caractérisé en ce qu'**il consiste
- à utiliser, pour le boîtier, un boîtier hyperfréquence (L1-L4, M1-M4, 1, 2, 3) comportant au moins :
■ un mini-circuit imprimé ayant deux faces parallèles :
• une première face comportant des conducteurs (L1-L4) et des plans de masse (M1-M4 ; M1ₐ+M1_{b},M2ₐ,M3ₐ+M3_{b},M4ₐ) intercalés entre les conducteurs et
• une seconde face constituée par un plan de masse (2, 3) connecté aux plans de masse de la première face, et
■ un puce (P) connectée aux conducteurs (L1-L4) et située sur la première face dudit mini-circuit imprimé;
- à réaliser le circuit imprimé d'accueil (L1'-L4',M1'-M4', 6, 7, 8) de telle sorte qu'il présente une première face avec, dans une zone dédiée au boîtier, des conducteurs (L1'-L4') et des plans de masse (M1'-M4' ; M1'ₐ + M1'_{b}, M2'ₐ, M3'ₐ+M3'_{b} , M4'ₐ ) et une seconde face constituée par un plan de masse (7, 8) connecté aux plans de masse de la première face du circuit imprimé d'accueil, les premières faces du mini-circuit imprimé et du circuit imprimé d'accueil ayant d'une part leurs plans de masse et d'autre part leurs conducteurs qui, dans une position prédéterminée (ABCD/A'B'C'D') du boîtier sur le circuit imprimer d'accueil sont en contact biunivoque,
- à placer le boîtier dans la position prédéterminée
- et à connecter le boîtier au circuit imprimé d'accueil par soudure (S) des conducteurs et des plans de masse en contact biunivoque. conducteurs et des plans de masse en contact biunivoque.

2. Boîtier hyperfréquence comportant :
- un mini circuit imprimé avec une première et une seconde face,
■ la première face comportant des conducteurs (L1-L4) et
■ la seconde face étant constituée par un plan de masse (2, 3), et
- une puce (P) connectée aux conducteurs et située sur la première face dudit mini circuit imprimé
**caractérisé en ce que** :
- la première face comporte des plans de masse (M1-M4; M1ₐ+M1_{b},M2ₐ,M3ₐ+M3_{b},M4ₐ), qui sont intercalés entre les conducteurs (L1-L4) et **en ce que**
- le mini circuit imprimé comporte des connexions (Ha, Hb ; M1ₐ - M4ₐ) entre les plans de masse de la première face et le plan de masse de la seconde face.

3. Boîtier hyperfréquence selon la revendication 2, **caractérisé en ce que** les connexions sont réalisées par des trous à parois métallisées (Ha, Hb).

4. Boîtier hyperfréquence selon la revendication 2, **caractérisé en ce que** le mini circuit imprimé comporte un support mécanique conducteur (3) avec un premier et un second côté sensiblement parallèles entre eux, un substrat isolant (1) avec un premier et un second côté sensiblement parallèles entre eux et parallèles au premier et au second côté du support, le second côté du substrat étant fixé par une couche conductrice (2) sur le premier côté du support, **en ce que** le support présente n, avec n entier au moins égal à 1, bossages (3b, M1ₐ - M4ₐ) sur son premier côté et **en ce que** la forme du substrat et sa position par rapport au support (3) sont telles que les bossages sont laissés à découvert par le substrat.

5. Boîtier hyperfréquence selon la revendication 4, **caractérisé en ce que** l'un des n bossages (3b) est destiné à la puce (P) qui est soudée sur ce bossage.

6. Boîtier hyperfréquence selon la revendication 4, **caractérisé en ce que** les bossages, au moins pour certains d'entre eux (M1ₐ -M4ₐ) sont situés contre la périphérie du substrat (1), **en ce que** ces bossages contre la périphérie du substrat présentent chacun une partie supérieure, sensiblement au niveau du premier côté du substrat, et **en ce que** ces parties supérieures complètent les plans de masse de la première face du mini circuit imprimé.

7. Boîtier hyperfréquence selon l'une des revendications 4 à 6, **caractérisé en ce que** les bossages (3b, M1ₐ M4ₐ) du support (3) sont obtenus par emboutissage.

8. Circuit imprimé d'accueil de boîtier hyperfréquence, pour la mise en oeuvre d'un procédé de montage d'un boîtier sur ce circuit imprimé d'accueil, ce circuit imprimé d'accueil comportant une première et une seconde face, la première face comportant, dans une zone d'accueil, des conducteurs (L1'-L4') et la seconde face étant constituée par un plan de masse (7, 8), **caractérisé en ce que** la première face comporte des plans de masse dans la zone d'accueil, **en ce que** ces plans de masse sont intercalés entre les conducteurs (L1'-L4') et **en ce que** le circuit imprimé d'accueil comporte des connexions (Ha', Hb' ; M1'ₐ - M4'ₐ) entre les plans de masse de la première face et le plan de masse de la seconde face.

9. Circuit imprimé d'accueil selon la revendication 8, **caractérisé en ce en ce qu'**il comporte une cavité (K) qui débouche dans la zone d'accueil par une ouverture qui est entourée par les conducteurs et les plans de masse de la première face.

10. Circuit imprimé d'accueil selon la revendication 8, **caractérisé** les connexions sont réalisées par des trous à parois métallisées (Ha', Hb').

## Patentansprüche

1. Verfahren für die Montage eines Mikrowellengehäuses auf einer Aufnahmeleiterplatte, **dadurch gekennzeichnet, daß** das Verfahren aus folgenden Schritten besteht,
- für das Gehäuse wird ein Mikrowellengehäuse (L1-L4, M1-M4, 1, 2, 3) verwendet, das wenigstens:
- eine Minileiterplatte umfaßt, die zwei parallele Flächen aufweist,
- wovon eine erste Fläche Leiter (L1-L4) und zwischen den Leitern geschaltete Masseebenen (M1-M4; M1ₐ₊M1_{b}, M2ₐ, M3ₐ₊M3_{b}, M4ₐ) aufweist und
- wovon eine zweite Fläche durch eine mit den Masseebenen der ersten Fläche verbundene Masseebene (2, 3) gebildet ist, und
- einen Chip (P), der mit den Leitern (L1-L4) verbunden ist und sich auf der ersten Fläche der Minileiterplatte befindet;
- die Aufnahmeleiterplatte (L1'-L4', M1'-M4', 6, 7, 8) wird in der Weise verwirklicht, daß sie eine erste Fläche aufweist, die in einer für das Gehäuse vorgesehenen Zone Leiter (L1'-L4') und Masseebenen (M1'-M4'; M1'ₐ+M1'_{b}, M2'ₐ, M3'ₐ + M3'_{b}, M4'ₐ) aufweist, und eine zweite Fläche aufweist, die durch eine mit den Masseebenen der ersten Fläche der Aufnahmeleiterplatte verbundene Masseebene (7, 8) gebildet ist, wobei die ersten Flächen der Minileiterplatte und der Aufnahmeleiterplatte einerseits ihre Masseebenen und andererseits ihre Leiter aufweisen, die in einer vorgegebenen Position (ABCD/A'B'C'D') des Gehäuses auf der Aufnahmeleiterplatte in einem eineindeutigen Kontakt sind,
- das Gehäuse wird an der vorgegebenen Position angeordnet,
- und das Gehäuse wird mit der Aufnahmeleiterplatte durch Verlöten (S) der Leiter und der Masseebenen in eineindeutigem Kontakt verbunden.

2. Mikrowellengehäuse, mit:
- einer Minileiterplatte, die eine erste und eine zweite Fläche aufweist,
- wovon die erste Fläche Leiter (L1-L4) aufweist und
- wovon die zweite Fläche durch eine Masseebene (2, 3) gebildet ist, und
- einem Chip (P), der mit den Leitern verbunden ist und sich auf der ersten Fläche der Minileiterplatte befindet,
**dadurch gekennzeichnet, daß**
- die erste Fläche zwischen den Leitern (L1-L4) geschaltete Masseebenen (M1-M4; M1ₐ + M1_{b}, M2ₐ, M3ₐ + M3_{b}, M4ₐ) aufweist und **daß**
- die Minileiterplatte Verbindungen (Ha, Hb; M1ₐ-M4ₐ) zwischen den Masseebenen der ersten Fläche und der Masseebene der zweiten Fläche aufweist.

3. Mikrowellengehäuse nach Anspruch 2, **dadurch gekennzeichnet, daß** die Verbindungen durch Löcher mit metallisierten Wänden (Ha, Hb) verwirklicht sind.

4. Mikrowellengehäuse nach Anspruch 2, **dadurch gekennzeichnet, daß** die Minileiterplatte einen leitenden mechanischen Träger (3) mit einer ersten und einer zweiten Seite, die im wesentlichen zueinander parallel sind, und ein isolierendes Substrat (1) mit einer ersten und einer zweiten Seite umfaßt, zueinander und zur ersten und zur zweiten Seite des Trägers im wesentlichen parallel sind, wobei die zweite Seite des Substrats über eine leitende Schicht (2) an der ersten Seite des Trägers befestigt ist, **daß** der Träger auf seiner ersten Seite n Höcker (3b, M1ₐ-M4ₐ) aufweist, wobei n eine ganze Zahl und wenigstens gleich 1 ist, und **daß** die Form des Substrats und seine Position in bezug auf den Träger (3) derart sind, **daß** die Höcker durch das Substrat unabgedeckt gelassen werden.

5. Mikrowellengehäuse nach Anspruch 4, **dadurch gekennzeichnet, daß** einer der n Höcker (3b) für den Chip (P) bestimmt ist, der auf diesen Höcker gelötet ist.

6. Mikrowellengehäuse nach Anspruch 4, **dadurch gekennzeichnet, daß** sich zumindest einige der Höcker (Mlₐ-M4ₐ) am Umfang des Substrats (1) befinden, **daß** diese Höcker am Umfang des Substrats jeweils einen oberen Teil im wesentlichen auf Höhe der ersten Seite des Substrats aufweisen und **daß** diese oberen Teile die Masseebenen der ersten Fläche der Minileiterplatte vervollständigen.

7. Mikrowellengehäuse nach einem der Ansprüche 4 bis 6, **dadurch gekennzeichnet, daß** die Höcker (3b, M1ₐ-M4ₐ) des Trägers (3) durch Prägen erhalten werden.

8. Aufnahmeleiterplatte für ein Mikrowellengehäuse zur Verwendung in einem Verfahren für die Montage eines Gehäuses auf der Aufnahmeleiterplatte, wobei die Aufnahmeleiterplatte eine erste und eine zweite Fläche aufweist, wovon die erste Fläche in einer Aufnahmezone Leiter (L1'-L4') aufweist und die zweite Fläche durch eine Masseebene (7, 8) gebildet ist, **dadurch gekennzeichnet, daß** die erste Fläche in der Aufnahmezone Masseebenen aufweist, **daß** diese Masseebenen zwischen den Leitern (L1'-L4') geschaltet sind und **daß** die Aufnahmeleiterplatte Verbindungen (Ha', Hb'; M1'ₐ-M4'ₐ) zwischen den Masseebenen der ersten Fläche und der Masseebene der zweiten Fläche aufweist.

9. Aufnahmeleiterplatte nach Anspruch 8, **dadurch gekennzeichnet, daß** sie einen Hohlraum (K) aufweist, der in die Aufhahmezone durch eine Öffnung mündet, die von den Leitern und den Masseebenen der ersten Fläche umgeben ist.

10. Aufnahmeleiterplatte nach Anspruch 8, **dadurch gekennzeichnet, daß** die Verbindungen durch Löcher mit metallisierten Wänden (Ha', Hb') gebildet sind.

## Claims

1. Method for mounting of a microwave package on a receiving printed circuit, **characterized in that** it consists
- in using, for the package, a microwave package (L1-L4, M1-M4, 1, 2, 3) comprising at least:
■ a miniature printed circuit having two parallel faces:
● a first face comprising conductors (L1-L4) and earth planes (M1-M4; M1ₐ + M1_{b}, M2ₐ, M3ₐ + M3_{b}, M4ₐ) that are inserted between the conductors, and
● a second face consisting of an earth plane (2, 3) connected to the earth planes of the first face, and
■ a chip (P) connected to the conductors (L1-L4) and located on the first face of the said miniature printed circuit;
- in producing the receiving printed circuit (L1'-L4', M1'-M4', 6, 7, 8) in such a way that it has a first face with, in a region dedicated to the package, conductors (L1'-L4') and earth planes (M1'-M4'; M1'ₐ + M1'_{b}, M2'ₐ, M3'ₐ + M3 ' _{b}, M4'ₐ) and a second face consisting of an earth plane (7, 8) connected to the earth planes of the first face of the receiving printed circuit, the first faces of the miniature printed circuit and of the receiving printed circuit having, on the one hand, their earth planes and, on the other hand, their conductors which, in a predetermined position (ABCD/A'B'C'D') of the package on the receiving printed circuit, are in one-to-one contact,
- in placing the package in the predetermined position
- and in connecting the package to the receiving printed circuit by soldering (S) the conductors and the earth planes in one-to-one contact.

2. Microwave package comprising:
- a miniature printed circuit with first and second faces,
■ the first face having conductors (L1-L4), and
■ the second face consisting of an earth plane (2, 3), and
- a chip (p) connected to the conductors and located on the first face of the said miniature printed circuit;
**characterized in that**:
- the first face includes earth planes (M1-M4; M1ₐ + M1_{b}, M2ₐ, M3ₐ + M3_{b}, M4ₐ) that are inserted between the conductors (L1-L4) and **in that**
- the miniature printed circuit includes connections (Ha, Hb; M1ₐ - M4ₐ) between the earth planes of the first face and the earth plane of the second face.

3. Microwave package according to Claim 2, **characterized in that** the connections are produced by plated through-holes (Ha, Hb).

4. Microwave package according to Claim 2, **characterized in that** the miniature printed circuit includes a conductive mechanical support (3) with first and second sides which are more or less parallel to each other, an insulating substrate (1) with first and second sides which are more or less parallel to each other and parallel to the first and second sides of the support, the second side of the substrate being fastened by a conductive layer (2) to the first side of the support, **in that** the support has n tabs (3b, M1ₐ - M4ₐ) on a first side, n being an integer at least equal to 1, and **in that** the shape of the substrate and its position with respect to the support (3) are such that the tabs are left uncovered by the substrate.

5. Microwave package according to Claim 4, **characterized in that** one of the n tabs (3b) is intended for the chip (P) which is soldered to this tab.

6. Microwave package according to Claim 4, **characterized in that** the tabs, at least for some of them (M1ₐ - M4ₐ), are located against the periphery of the substrate (1), **in that** these tabs against the periphery of the substrate each have an upper part more or less level with the first side of the substrate and **in that** these upper parts complete the earth planes of the first face of the miniature printed circuit.

7. Microwave package according to one of Claims 4 to 6, **characterized in that** the tabs (3b, M1ₐ - M4ₐ) of the support (3) are obtained by drawing.

8. Printed circuit for receiving a microwave package, for the implementation of a process for mounting a package on this receiving printed circuit, this receiving printed circuit including first and second faces, the first face including, in a receiving region, conductors (L1'-L4') and the second face consisting of an earth plane (7, 8), **characterized in that** the first face includes earth planes in the receiving region, **in that** these earth planes are inserted between the conductors (L1'-L4') and **in that** the receiving printed circuit includes connections (Ha', Hb'; M1'ₐ - M4'ₐ) between the earth planes of the first face and the earth plane of the second face.

9. Receiving printed circuit according to Claim 8, **characterized in that** it includes a cavity (K) which runs into the receiving region via an opening which is surrounded by the conductors and the earth planes of the first face.

10. Receiving printed circuit according to Claim 8, **characterized in that** the connections are produced by plated through-holes (Ha', Hb').
